# EUROPEAN PATENT APPLICATION

(11) **EP 4 835 891 A1**
(43) Date of publication of application: **04.11.2026**
(21) Application number: 26168426.0
(22) Date of filing: 27.03.2026
(51) Int. Cl.: G10L 21/034

(54) **AUTOMATIC VOLUME CONTROL BASED ON VOICE SIGNAL**

(30) Priority: 30.04.2025 KR 20250057398
(71) Applicant: LG Electronics Inc., Yeongdeungpo-gu Seoul 07336 (KR)
(72) Inventor: KIM, Jongkun, 08592 Seoul (KR); LEE, Joonil, 08592 Seoul (KR); KIM, Kichul, 08592 Seoul (KR); CHOI, Byungkil, 08592 Seoul (KR)
(74) Representative: Vossius & Partner Patentanwälte Rechtsanwälte mbB

(57) **Abstract**

Embodiments of the present disclosure relate to a voice signal-based automatic volume control device including an object separator configured to separate an audio input signal into a voice signal and a non-voice signal; a voice signal processor configured to process the voice signal and determine a volume compensation value based on the voice signal and set volume information; a non-voice signal processor configured to process the non-voice signal; and a volume controller configured to control the volume of an audio output signal that is the sum of a voice output signal and a non-voice output signal processed and output by the voice signal processor and the non-voice signal processor based on the volume compensation value.

## Description

### FIELD

Embodiments of the present disclosure relate to volume control, more particularly, a method of automatic volume control based on a voice signal.

### BACKGROUND

Recently, with the emergence of various content platforms, viewers move between platforms to select and consume the content they want. Not only are the platforms providing content diverse, but the devices for playing the content are also diverse, such as TVs, mobile phones, and tablets. Device users have the inconvenience of having to adjust the volume each time they watch a selected program on a selected playback device due to differences in volume for each content, differences in volume for each content platform, and differences in volume implementation of the playback device.

One reason users turn up the volume is because the voice of a person in the program is not heard clearly while playing content. When the dialogue or important voices of a person are buried, it is difficult to understand the content, causing discomfort in viewing, so the overall volume can be increased to adjust the volume to a comfortable level when watching content. On the other hand, the reason for reducing the volume may be because the overall sound is too loud, or when a specific sound effect or music suddenly becomes loud, causing discomfort. In this way, there is the inconvenience of having to adjust the volume to a comfortable level when the volume is too low, loud, suddenly loud, or suddenly low.

Therefore, hardware manufacturers that manufacture devices that play content are developing automatic volume control technologies that emphasize the voice played on the content platform and suppress unnecessary noise or sudden volume changes in order to solve the inconvenience that may occur due to sound during the playback of various contents. However, most automatic volume control technologies operate by amplifying small signals and reducing signals that are too loud, which causes the human voice and background sound in the content to become louder and quieter at the same time. Therefore, although the overall volume increases, the recognition performance of important voices such as human dialogue may not improve, and there may be disadvantages such as a loss of immersion due to the loss of dynamics of background sounds by reducing loud signals.

### SUMMARY

Accordingly, one object of the embodiments of the present disclosure is to solve the above-noted disadvantages of the prior art, and to provide a method for improving voice recognition performance and maintaining the dynamics of background sounds when watching content by dividing sounds contained in various contents into voice and non-voice and implementing automatic volume control technology based on the size of the voice.

The objects of the present disclosure are not limited to those mentioned above, and other technical objects may be inferred from following embodiments.

To solve the objects of the present disclosure, according to various embodiments, a voice signal-based automatic volume control device may include an object separator configured to separate an audio input signal into a voice signal and a non-voice signal; a voice signal processor configured to process the voice signal and determine a volume compensation value based on the voice signal and set volume information; a non-voice signal processor configured to process the non-voice signal; and a volume controller configured to control the volume of an audio output signal that is the sum of a voice outputted signal and a non-voice output signal processed and output by the voice signal processor and the non-voice signal processor based on the volume compensation value.

According to one embodiment, the object separator may use an artificial intelligence algorithm to separate the audio input signal into the voice signal and the non-voice signal.

According to one embodiment, the voice signal processor may include a voice volume analyzer configured to calculate an average power of the voice signal; a volume compensator configured to determine the volume compensation value based on the average power of the voice signal calculated by the voice volume analyzer and the set volume information; a voice automatic gain controller configured to calculate a gain that compensates for the magnitude of the voice signal based on the average power and accumulated power of the voice signal; a voice normalizer configured to normalize the voice signal by reflecting the gain; and a voice equalizer configured to change the tone of the voice signal.

According to one embodiment, the voice volume analyzer may be configured to process the voice signal input in time into frames of a certain size, determine whether there is a voice signal within the frame, and if it determines that there is a voice signal, calculates the average power of the current frame, and calculate the accumulated power by accumulating the calculated average power.

According to one embodiment, the voice volume analyzer may calculate the accumulated power by multiplying the average power by a weight and adding the value obtained by multiplying the previous accumulated power by (1-weight), and the weight may have a value between 0 and 1.

According to one embodiment, the volume compensator may be configured to obtain volume information set by the user, compare the accumulated power with the set volume information, and determine the volume compensation value to increase or decrease the overall volume so that the accumulated power corresponds to the volume information.

According to one embodiment, the volume compensator may be configured to store the loudness of the voice signal previously set by the user, and compare the accumulated power with the stored loudness of the voice signal to determine the loudness compensation value for increasing or decreasing the overall loudness so that the accumulated power corresponds to the loudness of the voice signal.

According to one embodiment, the volume compensator may include a recognition device configured to verify personal information or biometric information, and the volume compensator may be configured to distinguish multiple users based on the recognition device, distinguish multiple content platforms used by the multiple users, store the volume of voice signals used by the multiple users for each of the multiple content platforms by time zone, obtain the volume of the voice signal set based on the currently viewed content platform, the recognized user, and the time zone, and compare the accumulated power with the acquired volume of the voice signal, and determine the volume compensation value for increasing or decreasing the overall volume so that the accumulated power corresponds to the volume of the voice signal.

According to one embodiment, the voice automatic gain controller may be configured to compare the average power with the set volume information, if the average power is smaller than the set volume, determine the gain by selecting a smaller value between the value obtained by multiplying the difference in the average power from the set volume by the amplification ratio and the maximum gain, and if the average power is larger than the set volume, determine the gain by selecting a larger value between the value obtained by multiplying the difference in the average power from the set volume by the attenuation ratio and the minimum gain.

According to one embodiment, the non-voice signal processor may include a sound field processor configured to provides a sound field effect to the non-voice signal; a non-voice volume analyzer configured to analyze the non-voice signal and calculate average power; a non-voice automatic gain controller configured to calculate a gain that compensates for the volume of the non-voice signal based on the average power and accumulated power of the non-voice signal analyzed by the non-voice volume analyzer; and a non-voice normalizer configured to normalize the non-voice signal by reflecting the gain.

According to one embodiment, the non-voice volume analyzer may be configured to process the non-voice signal input in real time in units of frames of a certain size, determines whether there is a non-voice signal within a current frame, and if it determines that there is no voice-voice signal, exclude the current frame from the average power calculation, and if it determines that there is a non-voice signal, calculate the average power of the current frame and calculates accumulated power by accumulating the calculated average power.

According to one embodiment, the non-voice automatic gain controller may be configured to determine the gain by selecting a larger value among the difference between the volume target value and the average power multiplied by the attenuation ratio and the minimum gain when the average power is greater than the average power in comparing the average power with the volume target value of the non-voice signal.

According to various embodiments, a method of voice signal-based automatic volume control may include an object separation operation of separating an audio input signal into a voice signal and a non-voice signal; a voice signal processing operation of processing the voice signal and determining a volume compensation value based on the voice signal and set volume information; a non-voice signal processing operation of processing the non-voice signal; and a volume control operation of controlling the volume of an audio output signal to which a voice output signal and a non-voice output signal processed and output in the voice signal processing operation and the non-voice signal processing operation are added based on the volume compensation value.

According to one embodiment, the object separation operation may include an operation of separating the audio input signal into a voice signal and a non-voice signal using an artificial intelligence algorithm.

According to one embodiment, the voice signal processing operation may include a voice volume analysis operation of calculating the average power of the voice signal; a volume compensation operation for determining the volume compensation value based on the average power of the voice signal calculated through the voice volume analysis operation and the set volume information; a voice automatic gain control operation of calculating a gain for compensating the magnitude of the voice signal based on the average power and accumulated power of the voice signal; a voice normalization operation for normalizing the voice signal by reflecting the gain; and a voice equalizer operation for modifying the tone of the voice signal.

According to one embodiment, the voice volume analysis operation may include an operation of processing the voice signal input in real time into frames of a certain size; an operation of determining whether there is a voice signal within a current frame; and an operation of calculating the average power of the current frame and calculating the accumulated power by accumulating the calculated average power if it is determined that there is a voice signal.

According to one embodiment, the voice volume analysis operation may include an operation of calculating the accumulated power by multiplying the average power by a weight and adding a value obtained by multiplying the previous accumulated power by (1-weight), and the weight may have a value between 0 and 1.

According to one embodiment, the volume compensation operation may include an operation of obtaining volume information set by a user; and an operation of comparing the accumulated power with the set volume information and determining the volume compensation value to increase or decrease the overall volume so that the accumulated power corresponds to the volume information.

According to one embodiment, the volume compensation operation may include an operation of storing the volume of a voice signal previously set by the user; and an operation of comparing the accumulated power with the stored volume of the voice signal to determine the volume compensation value for increasing or decreasing the overall volume so that the accumulated power corresponds to the volume of the voice signal.

According to one embodiment, the volume compensation operation may include an operation of distinguishing multiple users; an operation of distinguishing multiple content platforms used by the multiple users; an operation of storing the volume of a voice signal used by the multiple users for each of the multiple content platforms by time zone; an operation of obtaining the volume of a voice signal set based on the currently viewed content platform, the recognized user, and the time zone; and an operation of comparing the accumulated power with the obtained volume of the voice signal and determining the volume compensation value for increasing or decreasing the overall volume so that the accumulated power corresponds to the volume of the voice signal.

According to one embodiment, the voice automatic gain control operation may include an operation of determining a gain by selecting a smaller value among a value obtained by multiplying an amplification ratio by a difference in the average power at the set volume and a maximum volume when the average power is smaller than the set volume; and an operation of determining a gain by selecting a larger value among a value obtained by multiplying an amplification ratio by a difference in the average power at the set volume and a minimum volume when the average power is larger than the set volume.

According to one embodiment, the non-voice signal processing operation may include a sound field processing operation of applying a sound field effect to the non-voice signal; a non-voice volume analysis operation of analyzing the non-voice signal and calculating the average power of the non-voice signal; a non-voice automatic gain control operation of calculating a gain to compensate the volume of the non-voice signal based on the average power and accumulated power of the non-voice signal analyzed through the non-voice volume analysis operation; and a non-voice normalization operation of normalizing the non-voice signal by reflecting the gain.

According to one embodiment, the non-voice volume analysis operation may include an operation of processing the non-voice signal input in real time in units of frames of a certain size; an operation for determining whether there is a non-voice signal within a frame; an operation of excluding the non-voice signal from the average power calculation if it is determined that there is no non-voice signal; and an operation of calculating the average power of the current frame if it is determined that there is a non-voice signal, and calculating the accumulated power by accumulating the calculated average power.

According to one embodiment, the non-voice automatic gain control operation may include an operation of determining a gain by taking a larger value among the difference between the volume target value and the average power multiplied by the attenuation ratio and the minimum gain when the average power is greater than the average power when comparing the average power with the volume target value of the non-voice signal.

According to one embodiment, by analyzing the sounds contained in various contents and implementing automatic volume control technology based on the size of the voice, the recognition performance for voice may be improved.

According to one embodiment, It amplifies the content sound based on the voice volume without damaging the dynamics of the background sound, so that you can maintain a sense of presence when watching the content.

However, it should be understood that the detailed description and specific examples, while indicating preferred embodiments of the invention, are given by illustration only, since various changes and modifications within the spirit and scope of the invention will become apparent to those skilled in the art from this detailed description.

### BRIEF DESCRIPTION OF THE DRAWINGS

FIG. 1 is a schematic view of automatic volume control of an audio input signal according to one embodiment;
FIG. 2 is a view showing the frequency based on the size of an audio input signal after applying the automatic volume controller of FIG. 1 as a histogram;
FIG. 3 is a view showing the waveform of an audio input signal and the waveform of an audio output signal after applying the automatic volume controller of FIG. 1;
FIG. 4 is a view of a voice normalization volume controller that may separate and process an audio input signal into a voice signal and a non-voice signal according to one embodiment;
FIG. 5 is a diagram showing the frequency based on the size of the audio output signal after applying the voice normalization volume controller of FIG. 4 as a histogram;
FIG. 6 is a view showing the waveform of an audio output signal after applying the voice normalization volume controller of FIG. 4;
FIG. 7 is a view showing a voice signal-based automatic volume controller that automatically controls the volume based on the magnitude of the voice signal while processing the audio signal input by separating the voice signal and the non-voice signal according to various embodiments of the present disclosure;
FIG. 8 is a view showing the frequency based on the volume of an audio output signal output after the audio input signal is processed by the voice signal-based automatic volume controller 30 shown in FIG. 7 as a histogram; and
FIG. 9 is a view showing the waveform of an audio output signal output after being processed by the voice signal-based automatic volume controller shown in FIG. 7.

### DETAILED DESCRIPTION OF THE DISCLOSURE

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. "And/or" includes any combination of one or more of the associated configurations that can be defined.

It will be understood that when an element is referred to as being "connected with", "on" or "coupled to" another element, the element can be directly connected with the other element or intervening elements may also be present. In contrast, when an element is referred to as being "directly connected with" another element, there are no intervening elements present. "And/or" includes each and every combination of one or more of the items mentioned.

Terminology that is used in the present disclosure is limited to only for embodiments herewith but made only to make it easy to understand the present disclosure. Throughout the disclosure, each component can be provided as a single one or a plurality of ones, unless explicitly stated to the contrary. Further, the defined terms of the respective elements will be called other terms in the art. Terms such as "include" or "has" are used herein and should be understood that they are intended to indicate an existence of several components, functions or steps, disclosed in the specification, and it is also understood that greater or fewer components, functions, or steps may likewise be utilized.

These terms are generally only used to distinguish one element from another. It will be understood that the terms "first" and "second" are used herein to describe various components but these components should not be limited by these terms. The above terms are used only to distinguish one component from another.

It will be understood that although the terms first, second, etc. may be used herein to describe various elements, these elements should not be limited by these terms. These terms are generally only used to distinguish one element from another. It will be understood that the terms "first" and "second" are used herein to describe various components but these components should not be limited by these terms. The above terms are used only to distinguish one component from another. For example, a first component may be referred to as a second component and vice versa without departing from the scope of the invention. The singular expressions include plural expressions unless the context clearly dictates otherwise. For example, a first component may be referred to as a second component and vice versa without departing from the scope of the invention. The singular expressions include plural expressions unless the context clearly dictates otherwise. Terminology that is used in the present disclosure is limited to only for embodiments herewith but made only to make it easy to understand the present disclosure. Terms of respective elements used in the following description are terms defined taking into consideration of the functions obtained in the present invention. Therefore, these terms do not limit technical elements in the present invention. Further, the defined terms of the respective elements will be called other terms in the art.

The term of 'part' or 'module' used in embodiments may mean a software or hardware element such as an FPGA or ASIC, and the 'part' or 'module' may perform predetermined roles. However, 'part' or 'module' is not limited to the software or hardware. The "part" or "module" may be provided in an addressable storage medium and configured to cause one or more processors to execute. Accordingly, as one example, a "part" or "module" may include elements such as software elements, object-oriented software elements, class elements and task elements, as well as processes, functions, attributes, procedures, subroutines, segments of program code, drivers, firmware, microcode, circuitry, data, database, data structures, tables, arrays and variables. The functions provided within the elements and "parts" or "modules" may be combined and "sub-part" or "modules" or further separated into additional elements and "parts" or "modules.

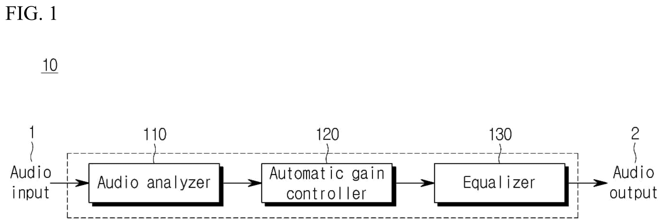

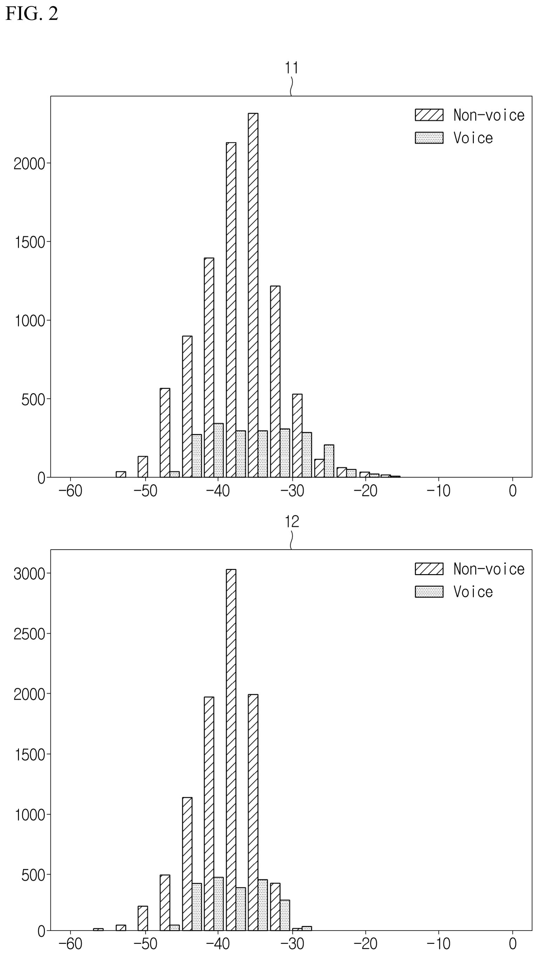

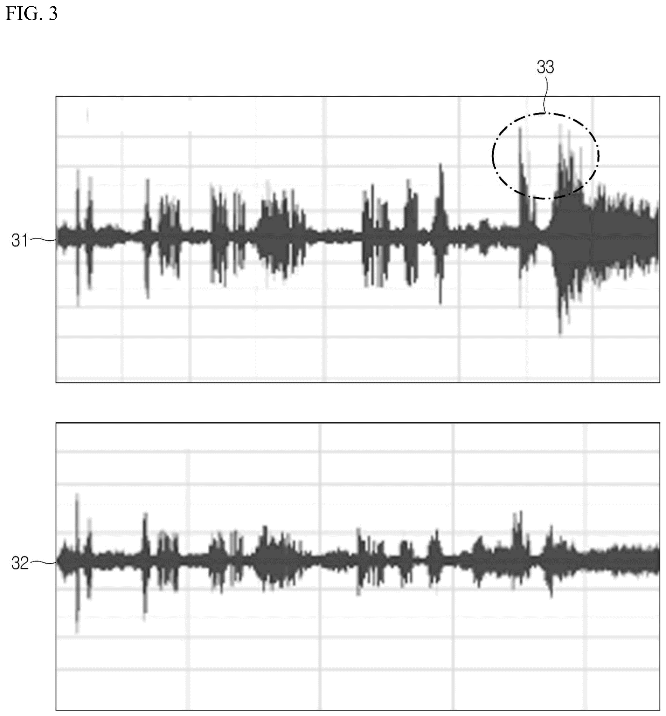

FIG. 1 is a schematic view of automatic volume control of an audio input signal according to one embodiment. FIG. 2 is a view showing the frequency based on the size of an audio input signal after applying the automatic volume controller of FIG. 1 as a histogram. FIG. 3 is a view showing the waveform of an audio input signal and the waveform of an audio output signal after applying the automatic volume controller of FIG. 1.

The automatic volume control technology of the automatic volume controller 10) is a technology that automatically adjusts the volume balance to resolve the discomfort of viewing content caused by the difference in volume in various audio environments, so that content viewers can comfortably listen to audio. The automatic volume control technology is a technology developed for the purpose of resolving the discomfort of viewers caused by the difference in volume between human voices and background sounds in content, the difference in volume between advertisements and content on a content platform, and the difference in volume between content, and can be applied to devices that play content (e.g., TV, smartphone, tablet, etc.).

The automatic volume controller 10 may analyze the size of an audio signal in real time and automatically amplify or reduce the size of the signal according to a set reference value and output it. The automatic volume controller 10 may play a role in making small sounds louder and loud sounds smaller to balance the overall volume and reduce the volume change of the audio input so that the listener can listen comfortably.

Referring to FIG. 1, the automatic volume controller 10 may include an audio analyzer 110, an automatic gain controller 120, and an equalizer 130.

The audio analyzer 110 may analyze the volume, dynamic range, etc. of the audio input signal 1.

The audio analyzer 110 may determine the volume of the audio signal by analyzing the amplitude of the audio input signal 1. The audio analyzer 110 may identify the peak value of the audio input signal 1 by analyzing the amplitude of the audio signal. If a signal exceeding the maximum peak value that the audio analyzer 110 may process occurs in the audio input signal 1, a clipping phenomenon in which the waveform is distorted and distorted may occur. Clipping is a distortion phenomenon that occurs when the amplitude of the audio signal exceeds the maximum limit that the audio analyzer 110 may process. When clipping occurs, the sound may be torn or rough, and unpleasant high-frequency sounds that were not originally there may be generated due to distortion of harmonic waves. In addition, it may cause fatigue in the ears due to deterioration of audio quality, which may cause discomfort to the viewer listening to the sound.

The audio analyzer 110 may analyze the dynamic range of the audio signal. The dynamic range refers to the difference between the smallest signal and the largest signal. The larger the dynamic range, the greater the change in the volume of the audio signal, and the smaller the dynamic range, the smaller the change in volume. If the dynamic range is too narrow, the sound may sound muffled, and if the dynamic range is too wide, the difference in volume may be extreme and the listener may feel uncomfortable. Therefore, it is necessary to adjust the dynamic range as needed so that a natural audio signal is output.

The automatic gain controller 120 may determine the gain of the audio input signal 1 in real time based on the result of the audio analyzer 110. The gain may be a ratio value multiplied by the audio signal to amplify or attenuate the audio signal. If the gain is greater than 1, the audio signal may be amplified, and if it is less than 1, the audio signal may be attenuated. According to one embodiment, if the volume of the audio input signal 1 is low overall, an average volume target value can be set, and a gain may be determined based on this value to amplify the volume of the audio input signal 1 at the same ratio.

The automatic gain controller 120 may limit the volume of the audio input signal 1 to be reduced below the maximum peak value in order to prevent the audio input signal 1 from being clipped. In addition, if the automatic gain controller 120 determines that the dynamic range is wide because the volume suddenly increases in a short period of time, it may narrow the dynamic range by increasing small sounds and decreasing large sounds. That is, the automatic gain controller 120 may increase the volume by amplifying small sounds, and may remove distorted sounds and sudden volume changes that may cause discomfort to the viewer.

The equalizer 130 may adjust the tone by amplifying or attenuating a specific frequency. While the automatic gain controller 120 amplifies or reduces the overall volume of the audio signal, the equalizer 130 may change the tone by amplifying or reducing the volume of a specific frequency band. For example, the equalizer 130 may amplify a frequency band corresponding to a human voice to make the voice more audible, and may remove a high frequency band or a low frequency band by applying a high pass filter or a low pass filter.

Referring to FIG. 2, the numeral reference 11 divides the audio input signal 1 received from the original content of the content platform into a voice signal and a non-voice signal, and displays the frequency based on the volume, and the numeral reference 12 divides the audio output signal 2 after applying the automatic volume controller 10 shown in FIG. 1 into a voice signal and a non-voice signal, and displays the frequency based on the volume.

Referring to the numeral reference 11, the average of the non-voice signal in the audio input signal 1 was -36.98 dB, and the average of the voice signal was -34.69 dB, and referring to the numeral reference 12, the average of the non-voice signal in the audio output signal 2 when the automatic volume controller 10 shown in FIG. 1 was applied was -38.80 dB, and the average of the voice signal was -37.98 dB. In other words, it may be confirmed that the automatic volume controller 10 reduced the overall volume.

Looking at the volume distribution of the audio signal, referring to numeral reference 11, it can be seen that the volume of the non-voice signal in the audio input signal 1 is approximately between -17 dB and -53 dB, and the volume of the voice signal is approximately between -20 dB and -47 dB. It can be seen that the volume of the non-voice signal in the audio output signal 2 to which the automatic volume controller 10 is applied is approximately between -29 dB and -53 dB, and the volume of the voice signal is approximately between -29 dB and -47 dB. That is, it can be seen that the automatic volume controller 10 has reduced the volume of the audio signal having a volume of -17 dB to -28 dB, thereby reducing the dynamic range.

Referring to FIG. 3, when comparing the waveform 31 of the audio input signal 1 with the waveform 32 of the audio output signal 2 that has passed through the automatic volume controller 10, it can be seen that the volume has been reduced in the loud part 33.

As a result, the viewer can hear a more comfortable sound, but in the case of audio signals that are produced with high sound sensitivity, such as background sound or sound effects, the sensitivity is reduced when the automatic volume controller 10 is applied, so there is a disadvantage that it may be difficult to feel a sense of presence. In addition, since the volume of audio signals including voice and non-voice is reduced at the same rate, it is not known whether the recognition performance of the voice signal has been improved.

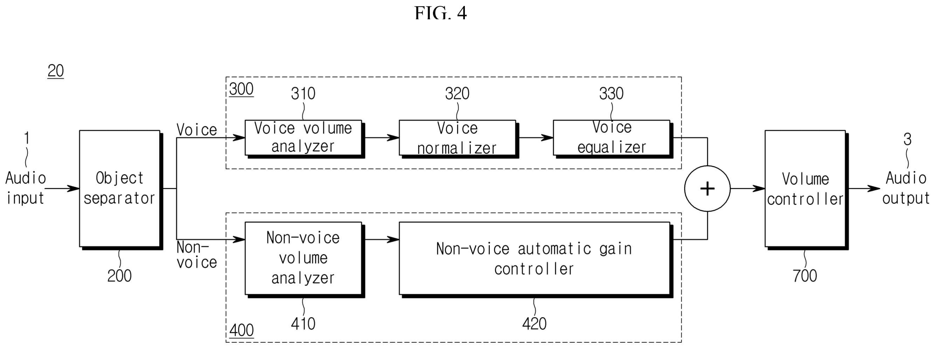

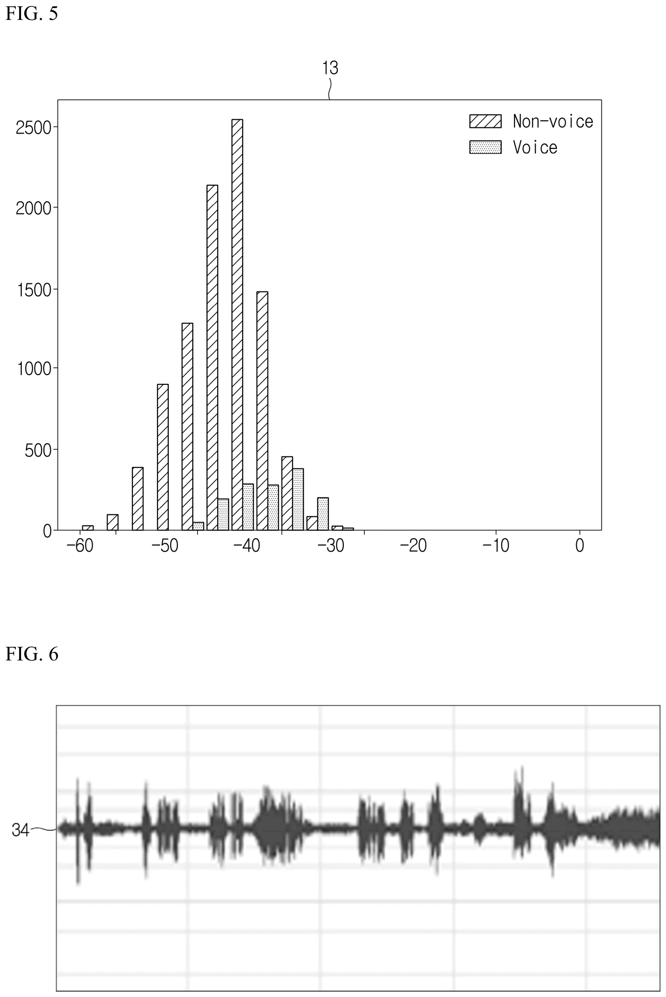

FIG. 4 is a view of a voice normalization volume controller that may separate and process an audio input signal into a voice signal and a non-voice signal according to one embodiment. FIG. 5 is a diagram showing the frequency based on the size of the audio output signal after applying the voice normalization volume controller of FIG. 4 as a histogram. FIG. 6 is a view showing the waveform of an audio output signal after applying the voice normalization volume controller of FIG. 4;

Referring to FIG. 4, the voice normalization volume controller 20 may include an object separator 200, a voice signal processor 300, a non-voice signal processor 400, and a volume controller 700.

The object separator 200 may play a role in separating an audio input signal 1 into a voice signal and a non-voice signal. According to one embodiment, the object separator 200 may use an artificial intelligence algorithm to separate an audio input signal 1 into a voice signal and a non-voice signal and output the same. The voice signal output from the object separator 200 may be transmitted to a voice signal processor 300, and the non-voice signal may be transmitted to the non-voice signal processor 400.

The voice signal processor 300 may include a voice volume analyzer 310, a voice normalizer 320, and a voice equalizer 300. The voice volume analyzer 310 may analyze the amplitude of the voice signal to analyze the magnitude of the voice signal. The voice volume analyzer 310 may determine the volume of the voice signal by analyzing the amplitude of the voice signal. In addition, the voice volume analyzer 310 may calculate the average power of the voice signal to determine the average volume of the entire voice signal.

The voice normalizer 320 may normalize the voice signal based on the average power of the voice signal calculated by the voice volume analyzer 310 to adjust the volume of the entire voice signal. In other words, the voice normalizer 320 may play a role in increasing or decreasing the volume of the entire voice signal at the same rate. In addition, the voice normalizer 320 may make the volume of the voice signal within the volume range between the minimum value and the maximum value that the voice normalization volume controller 20 may process through the normalization process.

The voice signal output through the voice normalizer 320 is transmitted to the voice equalizer 330, where the tone refinement process may be performed. The voice equalizer 330 may reduce the frequency bands that are uncomfortable to hear, such as plosives and sibilance, in the final voice signal, and emphasize the frequency bands corresponding to the voice, thereby making the overall tone soft and transmissive.

The non-voice signal processor 400 may include a non-voice volume analyzer 410 and a non-voice automatic gain controller 420. The non-voice volume analyzer 410 may calculate the minimum peak value, maximum peak value, and/or average power of the non-voice signal output from the object separator 200. Based on these values, the non-voice automatic gain controller 420 may set a target value, determine a gain based on the target value, and multiply the gain by the non-voice signal to amplify or attenuate the overall volume of the non-voice signal.

The non-voice automatic gain controller 420 may limit the non-voice signal to be reduced below the maximum peak value to prevent clipping if the volume of the non-voice signal is higher than the maximum peak value that the voice normalization volume controller 20 can process. In addition, the non-audio automatic gain controller 420 may narrow the dynamic range by increasing small sounds and decreasing large sounds when it is determined that the instantaneous dynamic range is wide because the sound suddenly becomes large in a short period of time. In other words, the non-audio automatic gain controller 420 may increase the volume by amplifying small sounds, and may eliminate factors that may cause discomfort to viewers due to changes in the volume of non-audio signals, such as distorted sounds and background sounds that suddenly change from small to large sounds.

The volume controller 700 may receive a signal that adds the voice signal processed by the voice signal processor 300 and the non-audio signal processed by the non-voice signal processor 400 as input and increase or decrease the volume of the input signal. The volume controller 700 has a function of adjusting the volume of the final audio output signal 3 of the content, and the user can adjust the volume using a device such as a volume knob or button connected to the volume controller 700.

Referring to FIG. 5, the numeral reference 13 divides the audio output signal 3 after applying the voice normalization volume controller 20 shown in FIG. 4 into a voice signal and a non-voice signal, and displays the frequency according to the volume.

Referring to the numeral references 11, 12, and 13 illustrated in FIG. 2 and FIG. 5, the average volume of the non-voice signal of the audio input signal 1 is -36.98 dB, the average volume of the non-voice signal of the audio output signal 2 when the automatic volume controller 10 shown in FIG. 2 is applied is -38.80 dB, and the average volume of the non-voice signal of the audio output signal 3 when the voice normalization volume controller 20 shown in FIG. 4 is applied is -42.70 dB. Meanwhile, the average volume of the voice signal of the audio input signal 1 was -34.69 dB, the average volume of the voice signal of the audio output signal 2 when the automatic volume controller 10 shown in FIG. 2 was applied was -37.98 dB, and the average volume of the voice signal of the audio output signal 3 when the voice normalization volume controller 20 of Fig. 4 was applied was -37.47 dB.

In the case of the voice signal, the volume of the audio output signals 2 and 3 of the automatic volume controller 10 and the voice normalization volume controller 20 decreased compared to the volume of the audio input signal 1, but it can be seen that the automatic volume controller 10 and the voice normalization volume controller 20 do not have a large difference in volume. In other words, it can be seen that the automatic volume controller 10 and the voice normalization volume controller 20 process the voice signal according to the same/similar conditions.

In the case of a non-voice signal, it can be seen that the average volume when the voice normalization volume controller 20 is applied is significantly smaller than the average volume of the audio input signal 2. That is, the voice normalization volume controller 20 may apply different gains to the voice signal and the non-voice signal to make the volume of the voice signal that a person wants to perceive larger than the volume of the non-voice signal. Accordingly, the voice normalization volume controller 20 may emphasize the voice signal more than the non-voice signal.

Looking at the volume distribution of the audio signal, referring to the numeral reference 11 of FIG. 2, it can be seen that the volume of the non-voice signal in the audio input signal 1 is approximately between -17 dB and -53 dB, and the volume of the voice signal is approximately between -20 dB and -47 dB. Referring to the numeral reference 13 of FIG. 5, it can be seen that the volume of the non-voice signal in the audio output signal 3 to which the voice normalization volume controller 20 is applied is approximately between -32 dB and -59 dB, and the volume of the voice signal is approximately between -32 dB and -47 dB. That is, it can be seen that the voice normalization volume controller 20 reduces the volume of the non-voice signal more than the volume of the voice signal, and reduces the volume in the audio signal having a volume of -17 dB to -31 dB, thereby reducing the dynamic range.

Referring to FIG. 6, it can be seen that the waveform 34 of the audio output signal 3 that passed through the voice normalization volume controller 20 reduces the volume in the part 310 where the volume is large in the audio input signal 10.

As a result, it can be judged that the voice normalization volume controller 20, which processes audio by separating it into voice and non-voice, processes the voice signal similarly when compared to the automatic volume controller 10, so that the processing result does not differ significantly. On the other hand, it can be seen that the voice normalization volume controller 20 reduces the volume more than the voice signal while making the dynamic range of the non-voice signal similar to the dynamic range of the non-voice signal of the audio input signal 1. The voice normalization volume controller 20 may process sounds such as background noise or sound effects closer to the background noise of the original audio signal than the automatic volume controller 10, and since it separates the non-voice signal and the voice signal and processes them individually, it can process them more effectively according to their respective characteristics. However, it may not be possible to adjust the volume ratio between the voice signal and the non-voice signal.

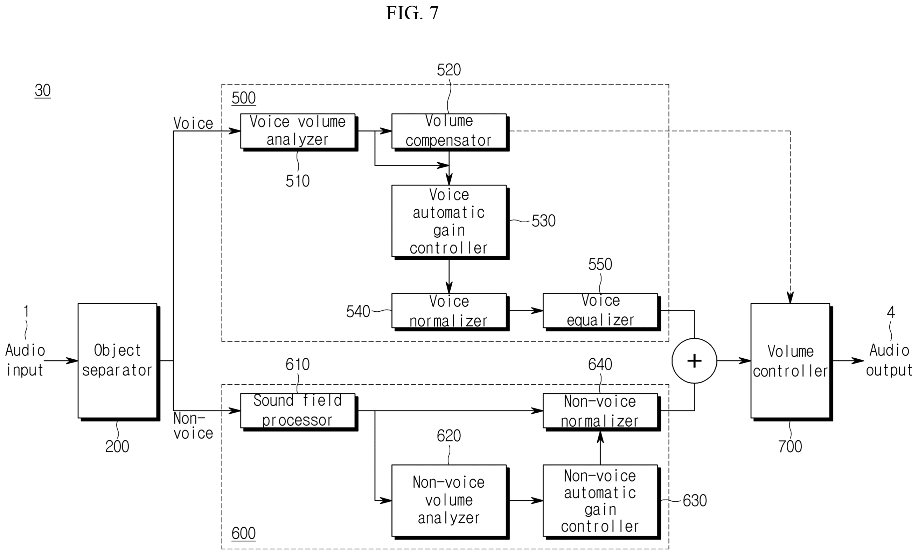

FIG. 7 is a view showing a voice signal-based automatic volume controller that automatically controls the volume based on the magnitude of the voice signal while processing the audio signal input by separating the voice signal and the non-voice signal according to various embodiments of the present disclosure.

Referring to FIG. 7, the voice signal-based automatic volume controller 30 may include an object separator 200, a voice signal processor 500, a non-voice signal processor 600, and a volume controller 700.

The voice signal-based automatic volume controller 30 may include at least one processor (not shown) or a digital signal processor DSP, and may process each function described in FIG. 7.

In the voice signal-based automatic volume controller 30, the object separator 200 may separate an audio input signal into a voice signal and a non-voice signal and output the separated signal. According to one embodiment, the object separator 200 may utilize an artificial intelligence algorithm that separates an audio signal of a content to be played, i.e., an audio input signal, into a voice signal and a non-voice signal.

The voice signal processor 500 may process a voice signal separated and output by the object separator 200. The voice signal processor 500 may be equipped with a voice volume analyzer 510, a volume compensator 520, an automatic voice gain controller 530, a voice normalizer 540, and a voice equalizer 550.

The voice volume analyzer 510 may calculate the average power of a voice signal input in real time. At this time, the voice volume analyzer 510 may process the voice signal input in real time in units of frames. According to one embodiment, if the voice volume analyzer 510 determines that there is no voice signal in a frame because the calculated average power is small, the voice volume analyzer 510 may exclude the average power calculated in the corresponding frame from subsequent calculations.

The voice volume analyzer 510 may calculate the accumulated power by accumulating the calculated average power. According to one embodiment, the voice volume analyzer 510 may calculate the accumulated power as (current average power × weight) + previous accumulated power × (1 - weight). Here, the weight is a value indicating the degree to which the currently calculated average power is reflected in the accumulated power and may have a value between 0 and 1. The accumulated power is also called smoothing power, and when the volume of the voice signal changes rapidly, the accumulated power can be used to reduce the change in volume.

The voice volume analyzer 510 may analyze the amplitude of the voice signal to determine the minimum peak value or maximum peak value of the voice signal.

The volume compensator 520 may monitor the accumulated power calculated by analyzing the voice signal in the voice volume analyzer 510. In addition, the volume compensator 520 may read the volume value set by the user. If the volume compensator 520 determines that the current volume of the voice signal is not suitable for the viewer to hear or is different from the volume value set by the user, it may play the role of volume compensation that increases or decreases the volume of the entire audio signal of the content.

The volume compensator 520 may be connected to a device that recognizes biometric information such as a camera, microphone, or fingerprint recognition that can distinguish a user using a device that plays content, and/or a device that may verify personal information.

According to one embodiment, the volume compensator 520 may store an average of the corresponding volume in the personal account when a user who has logged in to the personal account of the device that plays content adjusts the volume and sets it, and may later set the overall volume size according to the recognized individual based on the volume size stored for each individual. Accordingly, personalization of volume control may be possible.

According to one embodiment, if a user who has logged in to a personal account of a device that plays content has different preferred volume levels by time zone, the volume compensator 520 may store the average volume level by time zone in the personal account, and later, based on the volume level of each time zone saved for each individual, the overall volume level may be set according to the recognized individual and time zone.

According to one embodiment, if a user who has logged in to a personal account of a device that plays content has adjusted the volume level according to the content platform, the volume compensator 520 may store the average volume level used on the corresponding platform in the personal account, and later, based on the volume level saved for each individual when accessing the corresponding platform, the overall volume level may be set according to the recognized individual.

The voice automatic gain controller 530 may perform a function of amplifying or attenuating a voice signal. At this time, the gain can be set for amplifying or attenuating the signal. The gain of the voice signal can be determined based on the average power result of the voice volume analyzer 510 and the volume target value determined by the volume compensator 520.

The voice automatic gain controller 530 compares the average power of the voice volume analyzer 510 with the volume target value of the volume compensator 520, and if the average power is small, it may take the smaller value among the value obtained by multiplying the difference between the average power and the amplification ratio from the volume target value and the maximum gain as the gain. Here, the maximum gain may be the maximum value that can increase the magnitude of the voice signal in the device to the greatest extent.

The voice automatic gain controller 530 compares the average power of the voice volume analyzer 510 with the volume target value of the volume compensator 520, and if the average power is large, it may obtain a gain by taking a larger value between the difference between the average power and the volume target value multiplied by the attenuation ratio and the minimum gain. Here, the minimum gain may be the minimum value that can reduce the magnitude of the voice signal the most.

The gain determined by the voice automatic gain controller 530 is transmitted to the voice normalizer 540 and goes through a normalization process of the voice signal. The normalization process of the voice signal may increase the volume of the entire voice signal to improve the clarity of the voice signal. In addition, it is a process that allows the listener to hear the voice signal comfortably. In the case of a voice signal that is higher than the maximum volume, it can be attenuated to a value lower than the maximum volume to prevent distortion that may occur in the voice signal. In the case of a voice signal that is lower than the minimum volume and therefore difficult to hear, it can be amplified to a value higher than the minimum volume to increase the volume of the voice signal. In this way, the normalization process of the voice signal can mean processing the voice signal to make it into a volume preferred by the viewer.

The voice signal output through the voice normalizer 540 is transmitted to the voice equalizer 550. The voice equalizer 550 may reduce unnecessary noise in the voice signal and adjust the human voice to a clearer and more pleasant sound. The voice equalizer 550 may reduce sharp and tiring sounds corresponding to sibilance in the 4 kHz to 6 kHz band, remove plosive sounds in the 150 Hz band, and boost the human voice part corresponding to 300 Hz to 500 Hz to increase the clarity of the voice signal. The voice equalizer 330 may create a voice signal optimized for the listener by emphasizing or reducing a specific frequency band.

The non-voice signal processor 600 may include a sound field processor 610, a non-voice volume analyzer 620, a non-voice automatic gain controller 630, and a non-voice normalizer 640.

Most non-voice signals separated from audio signals are often background sounds or sound effects for enhancing the sense of presence. Therefore, the producer may add sound or sound field effects so that the viewer can immerse himself in the atmosphere or scene of the content. The sound field processor 610 may be added to make the sound more vivid. The sound field processor 610 may include sound field processing technology and algorithms, and representative sound field processing technologies and algorithms include Dolby Atmos, DTS: X, and 3D Audio.

The non-voice volume analyzer 620 may calculate the average power of the non-voice signal input in real time. At this time, the non-voice signal input in real time may be processed in units of frames. Therefore, it is possible to determine whether there is a non-voice signal in one frame and exclude frames without a signal from the calculation. The average power calculated in this way may be accumulated and reflected, and the accumulated power may be calculated. The accumulated power can be calculated as (current average power × weight) + previous accumulated power × (1-weight). Here, the weight is a value indicating the degree to which the currently calculated average power is reflected in the accumulated power and can have a value between 0 and 1. This accumulated power is also called smoothing power, and when the volume of the non-voice signal changes rapidly, the accumulated power may be used to reduce the range of the volume change.

The non-voice volume analyzer 620 may analyze the amplitude of the voice signal to identify the minimum peak value or maximum peak value of the non-voice signal. According to one embodiment, the non-voice volume analyzer 620 may calculate the accumulated power to help reduce or increase the volume when a non-voice signal exceeding the range of the peak value is input.

The non-voice automatic gain controller 630 may perform a function of amplifying or attenuating the voice signal. At this time, each gain can be set for amplifying or attenuating the signal. The gain of the non-voice signal may be determined based on the average power calculation result of the non-voice volume analyzer 620 and the volume target value of the non-voice signal.

The non-voice automatic gain controller 630 may compare the average power of the non-voice volume analyzer 620 with the volume target value, and if the average power is small, the smaller value between the value obtained by multiplying the difference in average power from the volume target value by the amplification ratio and the maximum gain can be used as the gain. Here, the maximum gain may be the maximum value that may increase the size of the non-voice signal the most in the device.

The non-voice automatic gain controller 630 may obtain a gain by comparing the average power of the non-voice volume analyzer 620 with the volume target value and, if the average power is large, taking a larger value between the difference between the average power and the volume target value multiplied by the attenuation ratio and the minimum gain. Here, the minimum gain may be the minimum value that can reduce the size of the non-voice signal the most.

The gain determined by the non-voice automatic gain controller 630 is transferred to the non-voice normalizer 640, and the non-voice normalizer 640 may be used to normalize the non-voice signal. The normalization process of the non-voice signal is a process that allows the listener to comfortably hear the entire non-voice signal, and in the case of a non-voice signal with a volume higher than the maximum peak value, it is attenuated to a value lower than the maximum peak value to prevent distortion that may occur in the non-voice signal.

The normalization process of the non-voice signal may be performed within a range that prevents distortion of the non-voice signal with a volume higher than the maximum peak value and does not destroy the dynamic range of the non-voice signal as much as possible. In other words, it may mean making the volume size such that the viewer does not feel uncomfortable when listening and does not damage the sound field effect intended by the producer.

The volume controller 700 receives as input an audio signal in which a voice signal processed by the voice signal processor 500 and a non-voice signal processed by the non-voice signal processor 600 are added, and can determine the output volume of the final audio signal based on the target value of the voice signal size output from the volume compensator 520 of the voice signal processor 500. The volume controller 700 has a function of adjusting the volume of the entire audio signal in consideration of the target value of the voice signal volume, and the viewer may adjust the volume of the content through a device such as a volume knob or button connected to the volume controller 700.

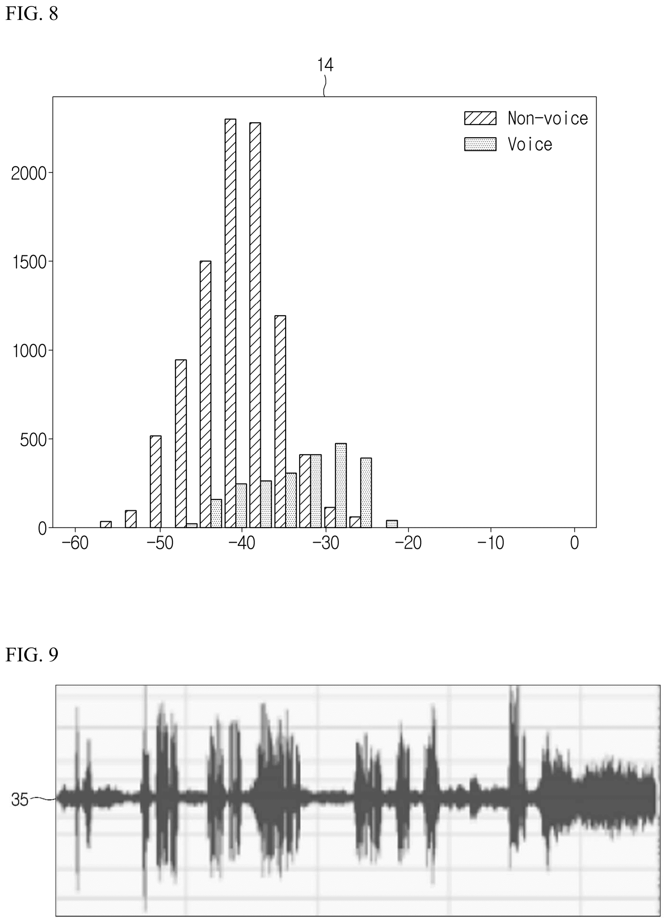

FIG. 8 is a view showing the frequency based on the volume of an audio output signal output after the audio input signal is processed by the voice signal-based automatic volume controller 30 shown in FIG. 7 as a histogram. FIG. 9 is a view showing the waveform of an audio output signal output after being processed by the voice signal-based automatic volume controller shown in FIG. 7.

Referring to FIGS. 2, 5 and 8, the average volumes of voice signals and non-voice signals of audio output signals of an audio input signal 1, an automatic volume controller 10, a voice normalization volume controller 20 and a voice signal-based automatic volume controller 30 according to one embodiment are as shown in Table 1 below.

**[Table 1]**

| | Audio input signal 1 | Audio output signal 2 of Automatic volume controller 10 | Voice Normalization audio output signal 3 of Volume controller 20 | Audio output signal 4 of Voice signal-based automatic volume controller 30 |
|---|---|---|---|---|
| Non-voice signal average loudness (dB) | -36.98 | -38.80 | -42.70 | -40.14 |
| Voice signal average loudness (dB) | 34.69 | -37.98 | -37.47 | -32.71 |

Referring to Table 1, it can be seen that the voice signal-based automatic volume controller 30 reduced the non-voice signal in the audio input signal from -36.98 to - 40.14, and increased the voice signal from -34.69 to -32.71. Accordingly, when watching content, the viewer can hear a clearer and louder voice signal when the voice signal-based automatic volume controller 30 is applied, and on the other hand, the viewer can hear background sounds with a relatively reduced volume. In particular, when comparing the average volume of the voice signal to the non-voice signal of the audio input signal 1 and each audio output signal 2, 3, and 4, the voice signal-based automatic volume controller 30 proposed in this document may make the voice signal louder than the non-voice signal, thereby improving the viewer's viewing environment.

Referring to FIGS. 2, 5, and 8, the distribution of the volume of voice signals and non-voice signals of audio output signals 2, 3, and 4 of an audio input signal 1, the automatic volume controller 10, the voice normalization volume controller 20, and the voice signal-based automatic volume controller 30 according to one embodiment is as shown in Table 2 below.

**[Table 2]**

| | Audio input signal 1 | Audio output signal 2 of Automatic volume controller 10 | Voice Normalization audio output signal 3 of Volume controller 20 | Audio output signal 4 of Voice signal-based automatic volume controller 30 |
|---|---|---|---|---|
| Non-voice signal volume distribution interval | -17 ~ -53 | -29 ~ -53 | -32 ~ -59 | -26 ~ -56 |
| Voice signal volume distribution interval | -20 ~ -47 | -29 ~ -47 | -32 ~ -47 | -23 ~ -44 |

Referring to Table 2, it can be seen that the voice signal-based automatic volume controller 30 has a wider dynamic range for both the voice signal and the non-voice signal than the aforementioned automatic volume controller 10 and the voice normalization volume controller 20. Referring to the waveform 35 illustrated in FIG. 9, it can be confirmed that the change in amplitude indicating the dynamic range of the voice signal-based automatic volume controller 30 is similar to the change in amplitude of the audio input signal 1.

Also, referring to Table 2 and FIG. 8, it can be seen that the distribution of the volume of the audio signal of the audio output signal 4 of the voice signal-based automatic volume controller 30 is similar to or slightly narrower than the audio input signal, while the distribution of the volume of the non-voice signal is similar to the audio input signal 1, but shifted to the left compared to the audio signal of the audio input signal 1. That is, it can be seen that the voice signal-based automatic volume controller 30 outputs a lower volume in the case of the non-voice signal than in the audio input signal 1. However, this is according to one embodiment, and the volume of the voice signal and/or the non-voice signal of the voice signal-based automatic volume controller 30 may be made larger than the volume of the audio input signal 1 by the viewer's operation.

The voice signal-based automatic volume controller 30 proposed in this document can automatically adjust the volume of a non-voice signal so that the voice signal can be heard well while adjusting the volume of the voice signal to suit the viewer's needs, thereby minimizing damage to the dynamic range of the non-voice signal and enhancing the sound field effect.

Although the present invention has been described with reference to the exemplified drawings, it is to be understood that the present invention is not limited to the embodiments and drawings disclosed in this specification, and those skilled in the art will appreciate that various modifications are possible without departing from the scope and spirit of the present invention.

Further, although the operating effects according to the configuration of the present invention are not explicitly described while describing an embodiment of the present invention, it should be appreciated that predictable effects are also to be recognized by the configuration.

## Claims

1. A voice signal-based automatic volume control device comprising:
an object separator configured to separate an audio input signal into a voice signal and a non-voice signal;
a voice signal processor configured to process the voice signal and determine a volume compensation value based on the voice signal and set volume information;
a non-voice signal processor configured to process the non-voice signal; and
a volume controller configured to control the volume of an audio output signal that is the sum of a voice output signal and a non-voice output signal processed and outputted by the non-voice signal processor and the voice signal processor based on the volume compensation value.

2. The automatic volume control device of claim 1, wherein the object separator uses an artificial intelligence algorithm to separate the audio input signal into the voice signal and the non-voice signal.

3. The automatic volume control device of claim 1, wherein the voice signal processor comprises:
a voice volume analyzer configured to calculate an average power of the voice signal;
a volume compensator configured to determine the volume compensation value based on the average power of the voice signal calculated by the voice volume analyzer and the set volume information;
a voice automatic gain controller configured to calculate a gain that compensates for the magnitude of the voice signal based on the average power and accumulated power of the voice signal;
a voice normalizer configured to normalize the voice signal by reflecting the gain; and
a voice equalizer configured to change the tone of the voice signal.

4. The automatic volume control device of claim 3, wherein the voice volume analyzer is configured to:
process the voice signal input in time into frames of a certain size,
determine whether there is a voice signal within the frame, and
if it determines that there is a voice signal, calculate the average power of the current frame and the accumulated power by accumulating the calculated average power,
wherein the voice volume analyzer is configured to calculate the accumulated power by multiplying the average power by a weight and adding the value obtained by multiplying the previous accumulated power by (1-weight), and
wherein the weight has a value between 0 and 1.

5. The automatic volume control device of claim 3, wherein the volume compensator is configured to:
store the loudness of the voice signal previously set by the user,
compare the accumulated power with the stored loudness of the voice signal, and
determine the loudness compensation value for increasing or decreasing the overall loudness so that the accumulated power corresponds to the loudness of the voice signal.

6. The automatic volume control device of claim 3, wherein the volume compensator further comprises a recognition device configured to verify personal information or biometric information, and
wherein the volume compensator is further configured to:
distinguish multiple users based on the recognition device,
distinguish multiple content platforms used by the multiple users,
store the volume of voice signals used by the multiple users for each of the multiple content platforms by time zone,
obtain the volume of the voice signal set based on the currently viewed content platform, the recognized user, and the time zone,
compare the accumulated power with the acquired volume of the voice signal, and
determine the volume compensation value for increasing or decreasing the overall volume so that the accumulated power corresponds to the volume of the voice signal.

7. The automatic volume control device of claim 3, wherein the voice automatic gain controller is configured to:
compare the average power with the set volume information,
if the average power is smaller than the set volume, determine the gain by selecting a smaller value between the value obtained by multiplying the difference in the average power from the set volume by the amplification ratio and the maximum gain, and
if the average power is larger than the set volume, determine the gain by selecting a larger value between the value obtained by multiplying the difference in the average power from the set volume by the attenuation ratio and the minimum gain.

8. The automatic volume control device of claim 1,
wherein the non-voice signal processor comprises:
a sound field processor configured to provides a sound field effect to the non-voice signal;
a non-voice volume analyzer configured to analyze the non-voice signal and calculate average power;
a non-voice automatic gain controller configured to calculate a gain that compensates for the volume of the non-voice signal based on the average power and accumulated power of the non-voice signal analyzed by the non-voice volume analyzer; and
a non-voice normalizer configured to normalize the non-voice signal by reflecting the gain,
wherein the non-voice volume analyzer is configured to:
process the non-voice signal input in real time in units of frames of a certain size,
determines whether there is a non-voice signal within a current frame, and
if it determines that there is no non-voice signal, exclude current frame from the average power calculation, and
if it determines that there is a non-voice signal, calculates the average power of the current frame and calculates accumulated power by accumulating the calculated average power, and
wherein the non-voice automatic gain controller is configured to determine the gain by selecting a larger value among the difference between the volume target value and the average power multiplied by the attenuation ratio and the minimum gain when the average power is greater than the average power in comparing the average power with the volume target value of the non-voice signal.

9. A method of voice signal-based automatic volume control comprising:
an object separation operation of separating an audio input signal into a voice signal and a non-voice signal;
a voice signal processing operation of processing the voice signal and determining a volume compensation value based on the voice signal and set volume information;
a non-voice signal processing operation of processing the non-voice signal; and
a volume control operation of controlling the volume of an audio output signal to which a voice output signal and a non-voice output signal processed and output in the voice signal processing operation and the non-voice signal processing operation are added based on the volume compensation value.

10. The method of voice signal-based automatic volume control of claim 9, wherein the object separation operation comprises an operation of separating the audio input signal into a voice signal and a non-voice signal using an artificial intelligence algorithm.

11. The method of voice signal-based automatic volume control of claim 9, wherein the voice signal processing operation comprises:
a voice volume analysis operation of calculating the average power of the voice signal;
a volume compensation operation for determining the volume compensation value based on the average power of the voice signal calculated through the voice volume analysis operation and the set volume information;
a voice automatic gain control operation of calculating a gain for compensating the magnitude of the voice signal based on the average power and accumulated power of the voice signal;
a voice normalization operation for normalizing the voice signal by reflecting the gain; and
a voice equalizer operation for modifying the tone of the voice signal, and
wherein the voice volume analysis operation comprises:
an operation of processing the voice signal input in real time into frames of a certain size;
an operation of determining whether there is a voice signal within a current frame; and
an operation of calculating the average power of the current frame and calculating the accumulated power by accumulating the calculated average power if it is determined that there is a voice signal,
wherein the operation of calculating the accumulated power comprises an operation of calculating the accumulated power by multiplying the average power by a weight and adding a value obtained by multiplying the previous accumulated power by (1-weight), and
wherein the weight has a value between 0 and 1.

12. The method of voice signal-based automatic volume control of claim 11, wherein the volume compensation operation comprises:
an operation of storing the volume of a voice signal previously set by the user; and
an operation of comparing the accumulated power with the stored volume of the voice signal to determine the volume compensation value for increasing or decreasing the overall volume so that the accumulated power corresponds to the volume of the voice signal.

13. The method of voice signal-based automatic volume control of claim 11, wherein the volume compensation operation comprises,
an operation of distinguishing multiple users;
an operation of distinguishing multiple content platforms used by the multiple users;
an operation of storing the volume of a voice signal used by the multiple users for each of the multiple content platforms by time zone;
an operation of obtaining the volume of a voice signal set based on the currently viewed content platform, the recognized user, and the time zone; and
an operation of comparing the accumulated power with the obtained volume of the voice signal and determining the volume compensation value for increasing or decreasing the overall volume so that the accumulated power corresponds to the volume of the voice signal.

14. The method of voice signal-based automatic volume control of claim 11, wherein the voice automatic gain control operation comprises:
an operation of determining a gain by selecting a smaller value among a value obtained by multiplying an amplification ratio by a difference in the average power at the set volume and a maximum volume when the average power is smaller than the set volume; and
an operation of determining a gain by selecting a larger value among a value obtained by multiplying an amplification ratio by a difference in the average power at the set volume and a minimum volume when the average power is larger than the set volume.

15. The method of voice signal-based automatic volume control of claim 9, wherein the non-voice signal processing operation comprises,
a sound field processing operation of applying a sound field effect to the non-voice signal;
a non-voice volume analysis operation of analyzing the non-voice signal and calculating the average power of the non-voice signal;
a non-voice automatic gain control operation of calculating a gain to compensate the volume of the non-voice signal based on the average power and accumulated power of the non-voice signal analyzed through the non-voice volume analysis operation; and
a non-voice normalization operation of normalizing the non-voice signal by reflecting the gain,
wherein the non-voice volume analysis operation comprises:
an operation of processing the non-voice signal input in real time in units of frames of a certain size;
an operation for determining whether there is a non-voice signal within a current frame;
an operation of excluding the current frame from the average power calculation if it is determined that there is no non-voice signal; and
an operation of calculating the average power of the current frame if it is determined that there is a non-voice signal, and calculating the accumulated power by accumulating the calculated average power, and
wherein the non-voice automatic gain control operation comprises an operation of determining a gain by taking a larger value among the difference between the volume target value and the average power multiplied by the attenuation ratio and the minimum gain when the average power is greater than the average power when comparing the average power with the volume target value of the non-voice signal.
